# EUROPEAN PATENT SPECIFICATION

(11) **EP 0 574 092 B1**
(45) Date of publication and mention of the grant of the patent: **17.12.1997**
(21) Application number: 93202205.6
(22) Date of filing: 30.09.1988
(51) Int. Cl.: G11B 7/26, G03F 1/00, B29D 17/00

(54) **Photo-masks**
Fotomasken
Photomasques

(30) Priority: 30.09.1987 JP 246653/87; 30.09.1987 JP 246654/87; 30.09.1987 JP 246655/87
(43) Date of publication of application: 15.12.1993
(62) Divisional of application: 88309089.6
(73) Proprietor: SHARP KABUSHIKI KAISHA, Osaka 545 (JP)
(72) Inventor: Ohta, Kenji, Kitakatsuragi-gun, Nara-ken (JP); Hirokane, Junji, Nara-shi, Nara-ken (JP); Shibata, Akira, Yamatokoriyama-shi, Nara-ken (JP); Van, Kazuo, Nara-shi, Nara-ken (JP); Inui, Tetsuya, Nara-shi, Nara-ken (JP); Nagahara, Yoshiyuki, Nara-shi, Nara-ken (JP); Mieda, Michinobu, Shiki-gun, Nara-ken (JP)
(74) Representative: W.P. THOMPSON & CO.

(56) References cited:
- US-A- 4 256 778
- US-A- 4 368 230
- PATENT ABSTRACTS OF JAPAN vol. 6, no. 112 (P-124)23 June 1982 & JP-A-57 041 639

## Description

This invention relates to a photo-mask that is used in the manufacture of optical memory devices with which information can be optically recorded, reproduced and erased.

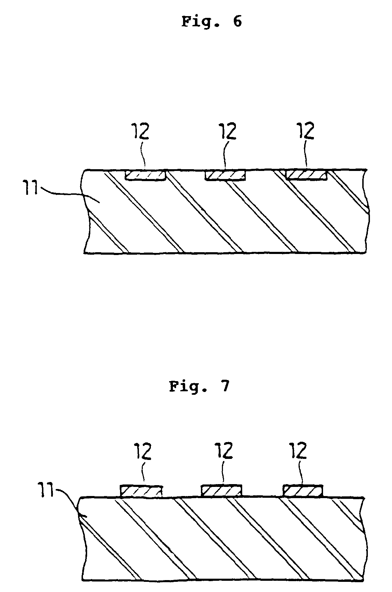

A conventional photo-mask is composed of, as shown in Figure 6, a light-permeable substrate 11 and patterned metal films 12 of Ta, Cr, Ti or the like that are buried in the substrate 11. Another conventional photo-mask is composed of, as shown in Figure 7, a light-permeable substrate 11 and patterned metal films 12 that are disposed on the top surface of the substrate 11. When guide grooves with a width of 0.6-1.3µm are formed on a glass substrate that constitutes an optical memory device by the use of the photo-mask, the photo-mask must be brought into contact with a photo-resist that has been disposed on the glass substrate, so that the mask-pattern of the metal films 12 can be transferred onto the photo-resist.

When the transference of the photo-mask onto the photo-resist is conducted, the photo-mask is stained because a piece of the photo-resist sticks to the photo-mask and/or dust enters into a gap between the photo-resist and the photo-mask. To remove the stain from the photo-mask, the photo-mask is subjected to an ultrasonic washing treatment, which causes peeling-off of the metal films 12, resulting in a loss of the mask-pattern of the metal films 12. Moreover, when the photo-mask shown in Figure 6 is brought into contact with a photo-resist that has been formed on the glass substrate of an optical memory device, static electricity occurs and is accumulated in the light-permeable substrate 11 that is non-conductive, which causes damage in the metal films 12.

JP-A-57-41639 discloses a photo-mask having a mask pattern made of metallic film, a metallic oxide film or mixed films thereof and an electrically conductive translucent film of indium oxide or tin oxide which covers the mask pattern and the substrate.

US-A-4256778 discloses a photo-mask comprising a light shielding film made of a metal such as Cr and a light permeable conductive film made of a metal oxide such as TiO₂, SnO₂, CdO etc.

US-A-4368230 relates to a photo-mask comprising a mask pattern made of a metallic element such as Au, Pb, Ta etc. or a composition containing the same, and a light shielding film made of a metal oxide such as an oxide of In, Sn, Ti, Zn etc.

The photo-mask of the present invention, which overcomes the above-discussed and numerous other disadvantages and deficiencies of the prior art, comprises a light-permeable substrate, a plurality of light-shielding films that are disposed on the substrate, said light-shielding films forming a mask pattern, and a light-permeable protective film which covers the surfaces of said substrate and the light-shielding films, the light-permeable protective film being made of a conductive substance and the light-shielding and light-permeable protective films being made of the same metallic substance.

The light-shielding films may be buried in said substrate so that the top surface of each of said light-shielding films is flush with the top surface of said substrate. Alternatively, the light-shielding films are disposed on the top surface of said substrate.

In further embodiments of the present invention, the photo-mask comprises a light-permeable substrate and a plurality of light-shielding films that form a mask-pattern, wherein said light-shielding films are buried in said substrate so that the outer surface of each of said light-shielding films is either above or below, but is not flush with the top surface of said substrate.

In a preferred embodiment, the light-shielding films project above the top surface of said substrate.

Thus, the invention described herein makes possible the objectives of (1) providing a photo-mask in which light-shielding films are protected by a protective film so that the light-shielding films cannot be peeled off, resulting in a prongation of the life of the photo-mask; (2) providing a photo-mask in which if the above-mentioned protective film is conductive, when the photo-mask is brought into contact with a photo-resist that has been disposed on the glass substrate of an optical memory device, the said conductive film comes into contact with the said photo-resist, and accordingly static electricity neither arises nor is accumulated in the light-permeable substrate of the photo-mask so that damage of the metal films of the photo-mask can be prevented, resulting in an enlargement of the life of the photo-mask.

This invention will be further illustrated by reference to the accompanying drawings in which:-
Fig. 1 is a sectional view showing a portion of one form of a photo-mask according to the present invention;
Fig. 2 is a sectional view showing a portion of another form of photo-mask according to the present invention;
Fig. 3 is a graph showing the relationship between the thickness of a conductive film of Ta and the permeability of ultraviolet rays in the cases where the light-permeable film that is disposed on the light-permeable substrate is conductive;
Fig. 4 is a sectional view showing a portion of yet another form of photo-mask according to the present invention;
Fig. 5 is a sectional view showing a portion of a still further form of photo-mask according to the present invention;
Fig. 6 is a sectional view showing a portion of a conventional photo-mask; and
Fig. 7 is a sectional view showing a portion of another conventional photo-mask.

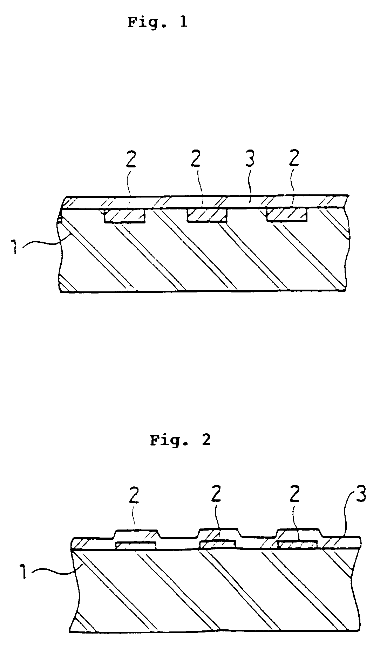

Referring to the accompanying drawings, Fig. 1 shows a photo-mask of this invention, in which a light-permeable substrate 1 made for example of quartz or soda lime, having a plurality of metal films 2 that are buried therein and a light-permeable film 3 that is disposed over the surface of the substrate 1 which includes the metal films 2.

In the embodiment of Fig. 1, one surface of each of the metal films 2 is flush with the surface of the substrate 1 which contains the metal films 2. The metal films 2 may be made of Ta, Ti, Cr, Mo (or alloys thereof), or like metallic material for shielding light. The metal films 2 can be also made of a substance such as TaSr, MoSi, or the like containing at least one of the above-mentioned metallic materials. In the production of the embodiment of Fig. 1 substrate 1 is etched so as to remove given portions of the substrate 1 corresponding to the desired mask-pattern and the above-mentioned metal film material is then disposed in the etched portions of the substrate 1 to form the light-shielding metal films 2 in the desired mask-pattern. The pattern of metal films 2 shield the substrate 1 from electromagnetic radiation such as ultraviolet rays when the substrate 1 is irradiated with such radiation. When a negative-type photo-resist is used for the manufacture of the guide grooves of an optical memory device, the above-mentioned metal films 2 are located on the portions of the substrate 1 that correspond to the portions of the photo-resist to be removed by a development treatment, whereas when a positive-type photo-resist is used, the above-mentioned metal films 2 are located on the portions of the substrate 1 that correspond to the portions of the photo-resist to remain after a development treatment.

The light-permeable film 3 that functions to protect the metal films 2 is made of the same substance as the films 2. The thickness of the film 3 is preferably about 30-300 nm. When the film 3 is exceedingly thin, the protection of the metal films 2 is reduced. When the SiO₂ film 3 is exceedingly thick, the transference of the mask-pattern of the metal films 2 onto the photo-resist that has been disposed on a glass substrate that constitutes an optical memory device cannot be carried out with absolute accuracy.

Because the metal films 2 are covered with the film 3, even when the photo-mask is subjected to an ultrasonic washing treatment, the metal films 2 are not peeled off.

The photo-mask of this invention is useful for the manufacture of an optical memory device such as an optmagnetic disk or the like. In general, the optmagnetic disk has a metal thin film as a memory medium that is made of an alloy of rare earth elements and transition elements. The thin alloy film tends to deteriorate due to moisture and/or oxygen. By the use of the photo-mask of this invention, the glass substrate of an optical memory device is exposed to light to form a latent image corresponding to the guide groove pattern, and the glass substrate is subjected to a development treatment and an etching treatment, resulting in guide grooves in the glass substrate. Then, thin alloy film of rare earth elements and transition elements is formed on the said glass substrate. According to the above-mentioned way, because there is little possibility that oxygen and/or moisture will reach the memory medium through the glass substrate, resulting in a high quality optical memory device.

Although the above-mentioned metal film 2 is a single film made of the above-mentioned metal, it can be also a double-layered film or a triple-layered film made of the said metal.

Fig. 2 shows another photo-mask of this invention, which comprises a light permeable substrate 1 made for example of a glass board of quartz, soda lime or the like, or a plastic board of acrylic resin, epoxy resin, or the like, a plurality of metal films 2 that are disposed on the top surface of the substrate 1, and a light-permeable film 3 that is disposed over the top surface of the substrate 1 including the metal films 2.

The metal films 2 form a mask pattern such as that of Example 1. Because the metal films 2 are not buried in the substrate 1, the formation of the metal films 2 on the substrate 1 can be easily carried out.

In another embodiment of the type illustrated in Fig. 1 the light-permeable film 3 is made of a conductive material such as Ta, Ti, Mo, Ni, AuCr, or the like. When the light-permeable film 3 is composed of a Ta thin film, the thickness thereof is set to be, for example, around 2-10 nm.

The Ta thin film 3 of the photo-mask is brought into contact with a photo-resist that has been formed on the glass substrate of an optical memory device, and the glass substrate is irradiated with ultraviolet rays through the photo-mask. Thereafter, the glass substrate is subjected to a development treatment and an etching treatment, resulting in guide grooves in the glass substrate. Because the Ta thin film 3 that is conductive comes into contact with the photo-resist, static electricity neither occurs nor is accumulated in the glass substrate during the light-exposure process.

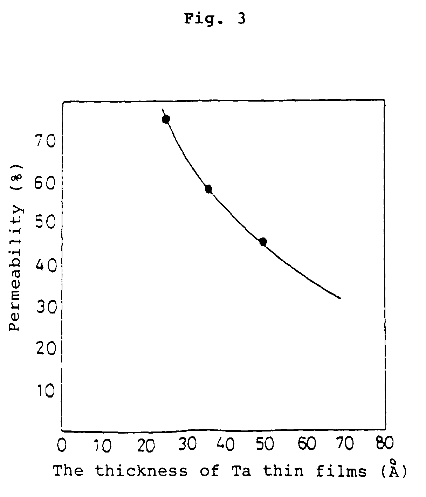

Fig. 3 shows the relationship between the thickness of the Ta thin film 3 and the permeability of ultraviolet rays therethrough, indicating that the permeability of ultraviolet rays is reduced with increasing thickness of the Ta thin film 3. Nevertheless, by increasing the duration of irradiation with ultraviolet rays is increased with increasing thickness of the Ta thin film 3, a sufficient light-exposure can be achieved thus compensating for the reduction in permeability resulting from an increase in the thickness of the Ta film.

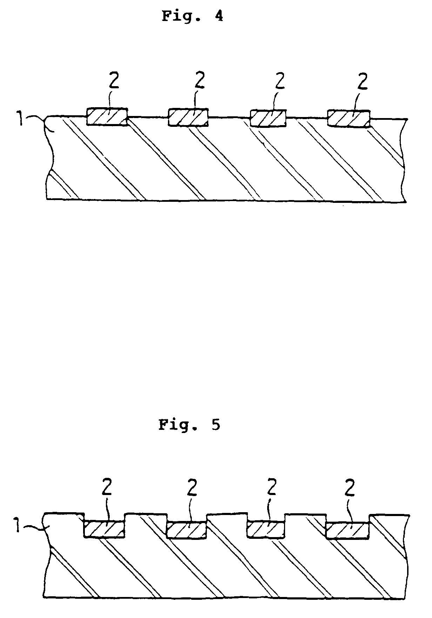

Fig. 4 shows another photo-mask of this invention, in which a light-permeable film (not shown) such as that of Fig. 1 or 2 is provided which covers the surface of the substrate 1 which includes the metal films 2. The photo-mask comprises a light-permeable substrate 1 made for example of quartz, soda lime, or the like and metal films 2 made for example of a conductive substance such as Ta, Ti, Ni Cr, Co, TaSi, MoSi, or the like. The metal films 2 are buried in the light-permeable substrate 1 such that a portion of each of the metal films 2 projects from the surface of the light-permeable substrate 1 which carries the metal films.

Fig. 5 shows another photo-mask of this invention, in which a light-permeable film (not shown) such as that of Fig. 1 or 2 is provided which covers the surface of the substrate 1 which includes the metal films 2. In this photo-mask the metal films 2 are buried in the light-permeable substrate 1 so that the surface of the substrate 1 is not flush with the surface of each of the metal films 2; namely, the outer surface of each of the metal films is lower than the surface of the substrate 1 which contains the metal films.

It is understood that various other modifications will be apparent to and can be readily made by those skilled in the art without departing from the scope and spirit of this invention. Accordingly, it is not intended that the scope of the claims appended hereto be limited to the description as set forth herein.

## Claims

1. A photo-mask comprising a light-permeable substrate (1), and a plurality of light-shielding films (2) that are disposed on the substrate, said light-shielding films forming a mask-pattern, wherein the photo-mask further comprises a light-permeable protective film (3) which covers the surfaces of the substrate (1) and the light-shielding films (2), the light-permeable protective film (3) being made of a conductive substance, characterised in that the light-shielding films (2) and the light-permeable protective film (3) are made of the same metallic substance.

2. A photo-mask according to claim 1, characterised in that the metallic substance is selected from Ta, Ti, Mo, Ni, Au and Cr.

3. A photo-mask according to claim 1, characterised in that the light-permeable protective film (3) is made of Ta and has a thickness of 2 to 10µm.

4. A photo-mask according to claim 1, characterised in that the light-shielding films (2) are made of a metal selected from Ta, Ti, Cr and Mo.

5. A photo-mask according to claim 4, characterised in that the metal is one of Ta and Ti.

6. A photo-mask according to any preceding claim, characterised in that the light-permeable protective film (3) has a thickness greater than that of the light-shielding films (2).

7. A photo-mask according to any preceding claim, characterised in that the light-shielding films (2) are buried in the light-permeable substrate (1)

8. A photo-mask according to claim 7, characterised in that the surfaces of the light-shielding films (2) are on a higher level than that of the light-permeable substrate (1).

9. A photo-mask according to claim 7, characterised in that the surfaces of the light-shielding films (2) are on approximately the same level as that of the light-permeable substrate (1).

10. A photo-mask according to claim 7, characterised in that the surfaces of the light-shielding films (2) are on a lower level than that of the light-permeable substrate (1).

11. A photo-mask according to any preceding claim, characterised in that the light-permeable substrate (1) is made of a glass substance selected from quartz and soda glass.

12. A photo-mask according to any of claims 1 to 10, characterised in that the light-permeable substrate (1) is made of a plastic selected from acrylic resins and epoxy resins.

## Patentansprüche

1. Photomaske mit einem lichtdurchlässigen Substrat (1) und einer Anzahl von Lichtabschirmungsfilmen (2), die auf dem Substrat angeordnet sind und ein Maskenmuster bilden, wobei die Photomaske ferner einen lichtdurchlässigen Schutzfilm (3) aufweist, der die Oberflächen des Substrats (1) und der Lichtabschirmungsfilme (2) bedeckt und aus einer leitenden Substanz besteht, **dadurch gekennzeichnet**, dass die Lichtabschirmungsfilme (2) und der lichtdurchlässige Schutzfilm (3) aus derselben Metallsubstanz bestehen.

2. Photomaske nach Anspruch 1, **dadurch gekennzeichnet**, dass die Metallsubstanz aus Ta, Ti, Mo, Ni, Au und Cr ausgewählt ist.

3. Photomaske nach Anspruch 1, **dadurch gekennzeichnet**, dass der lichtdurchlässige Schutzfilm (3) aus Ta besteht und eine Dicke von 2 bis 10 µm aufweist.

4. Photomaske nach Anspruch 1, **dadurch gekennzeichnet**, dass die Lichtabschirmungsfilme (2) aus einem aus Ta, Ti, Cr und Mo ausgewählten Metall bestehen.

5. Photomaske nach Anspruch 4, **dadurch gekennzeichnet**, dass das Metall Ta oder Ni ist.

6. Photomaske nach einem der vorstehenden Ansprüche, **dadurch gekennzeichnet**, dass der lichtdurchlässige Schutzfilm (3) eine größere Dicke als die Lichtabschirmungsfilme (2) aufweist.

7. Photomaske nach einem der vorstehenden Ansprüche, **dadurch gekennzeichnet**, dass die Lichtabschirmungsfilme (2) in das lichtdurchlässige Substrat (1) eingebettet sind.

8. Photomaske nach Anspruch 7, dadurch gekennzeichnet, dass die Oberflächen der Lichtabschirmungsfilme (2) auf einem höheren Niveau als die Oberfläche des lichtdurchlässigen Substrats (1) liegen.

9. Photomaske nach Anspruch 7, **dadurch gekennzeichnet**, dass die Oberflächen der Lichtabschirmungsfilme (2) ungefähr auf demselben Niveau wie die Oberfläche des lichtdurchlässigen Substrats (1) liegen.

10. Photomaske nach Anspruch 7, **dadurch gekennzeichnet**, dass die Oberflächen der Lichtabschirmungsfilme (2) auf einem niedrigeren Niveau als die Oberfläche des lichtdurchlässigen Substrats (1) liegen.

11. Photomaske nach einem der vorstehenden Ansprüche, **dadurch gekennzeichnet**, dass das lichtdurchlässige Substrat (1) aus einer aus Quarz und Natronglas ausgewählten Glassubstanz besteht.

12. Photomaske nach einem der Ansprüche 1 bis 10, **dadurch gekennzeichnet**, dass das lichtdurchlässige Substrat (1) aus einem aus Acrylharzen und Epoxidharzen ausgewählten Kunststoff besteht.

## Revendications

1. Photomasque comprenant un substrat (1) perméable à la lumière, et plusieurs films (2) formant écran de protection contre la lumière, disposés sur le substrat, lesdits films formant écran de protection contre la lumière formant un motif de masque, dans lequel le photomasque comprend en outre un film protecteur (3) perméable à la lumière, qui recouvre les surfaces du substrat (1) et des films (2) formant écran de protection contre la lumière, le film protecteur (3) perméable à la lumière étant fait d'une substance conductrice, caractérisé en ce que les films (2) formant écran de protection contre la lumière et le film protecteur (3) perméable à la lumière sont faits de la même substance métallique.

2. Photomasque selon la revendication 1, caractérisé en ce que la substance métallique est sélectionnée parmi Ta, Ti, Mo, Ni, Au et Cr.

3. Photomasque selon la revendication 1, caractérisé en ce que le film protecteur (3) perméable à la lumière est fait de Ta et a une épaisseur de 2 à 10 µm.

4. Photomasque selon la revendication 1, caractérisé en ce que les films (2) formant écran de protection contre la lumière sont faits d'un métal sélectionné parmi Ta, Ti, Cr et Mo.

5. Photomasque selon la revendication 4, caractérisé en ce que le métal est l'un parmi Ta et Ti.

6. Photomasque selon l'une quelconque des revendications précédentes, caractérisé en ce que le film protecteur (3) perméable à la lumière a une épaisseur supérieure à celle des films (2) formant écran de protection contre la lumière.

7. Photomasque selon l'une quelconque des revendications précédentes, caractérisé en ce que les films (2) formant écran de protection contre la lumière sont encastrés dans le substrat (1) perméable à la lumière.

8. Photomasque selon la revendication 7, caractérisé en ce que les surfaces des films (2) formant écran de protection contre la lumière sont à un niveau plus haut que celui du substrat (1) perméable à la lumière.

9. Photomasque selon la revendication 7, caractérisé en ce que les surfaces des films (2) formant écran de protection contre la lumière sont approximativement au même niveau que celui du substrat (1) perméable à la lumière.

10. Photomasque selon la revendication 7, caractérisé en ce que les surfaces des films (2) formant écran de protection contre la lumière sont à un niveau plus bas que celui du substrat (1) perméable à la lumière.

11. Photomasque selon l'une quelconque des revendications précédentes, caractérisé en ce que le substrat (1) perméable à la lumière est fait d'une substance de verre sélectionnée parmi le verre quartzeux et le verre à base de soude.

12. Photomasque selon l'une quelconque des revendications 1 à 10, caractérisé en ce que le substrat (1) perméable à la lumière est fait d'une matière plastique sélectionnée parmi les résines acryliques et les résines époxy.
